# EUROPEAN PATENT APPLICATION

(11) **EP 0 828 291 A2**
(43) Date of publication of application: **11.03.1998**
(21) Application number: 97202495.4
(22) Date of filing: 12.08.1997
(51) Int. Cl.: H01L 21/48, H01L 23/498

(54) **Fine pitch via formation using diffusion patterning techniques**

(30) Priority: 09.09.1996 US 709794
(71) Applicant: DELCO ELECTRONICS CORPORATION, Kokomo Indiana 46902 (US)
(72) Inventor: Drake, Jacquelynn Kay, Whiteland, Indiana 46184 (US); Knigga, Bradley Ray, Russiaville, Indiana 46979 (US)
(74) Representative: Denton, Michael John

(57) **Abstract**

A process for developing fine pitch vias in a dielectric material, such as thick-film and tape dielectrics, and dielectric materials formed thereby. Via formation is particularly amenable to diffusion patterning techniques, in which an imaging material is deposited in the form of complementary interdigitized shapes that maximize image material volume in order to form vias that extend completely through the dielectric material, while also assuring sufficient via spacing to prevent merging of adjacent vias during imaging. A preferred shape for the resulting diffusion-imaged vias, and therefore the deposited imaging material, is triangular, with the orientation of adjacent triangles being such that spacing between the deposited imaging material is comparable to the spacing between conductor traces associated with the resulting vias.

## Description

### Field of the Invention

The present invention generally relates to multilayer circuit boards composed of multiple conductor layers interlaid with one or more dielectric layers in order to achieve high circuit density. More particularly, this invention relates to the formation of fine-pitch vias used to interconnect adjacent circuit layers of a multilayer circuit.

### Background of the Invention

High density circuit boards have become highly desirable within the automotive, computer and mobile telecommunications industries as space limitations become more severe. Such circuit boards are generally constructed of a dielectric core on which multiple alternating layers of conductor and dielectric layers are deposited or laminated to form a multilayer structure of a desired number of circuit layers. The conductor layers include conductor traces that are electrically interconnected with different circuit components at the surface of the circuit board, while the dielectric layers electrically insulate the successive conductor layers from each other. Interstitial holes, referred to as vias, are required between adjacent conductor layers (i.e., through the intermediate dielectric layers) in order to electrically interconnect the conductor layers with each other or their respective circuit components at the surface of the multilayer structure. For this purpose, the vias can be metallized by plating or filled with an appropriate conductive material, such as a thick film metallization.

In the prior art, vias have been formed by control-depth drilling, laser drilling, plasma etching and diffusion patterning (DP), depending on the particular material and form of the dielectric layers, the role the vias perform in the multilayer circuit, and other factors pertaining to the nature of the multilayer circuit. Diffusion patterning, which is a particularly suitable method for forming fine pitch vias, entails precisely depositing a diffusion imaging paste on a dielectric layer of an appropriate composition, with placement and volume of the paste corresponding to the desired placement and depth, respectively, of the vias. The diffusion imaging paste then diffuses into the dielectric layer, both laterally and downwardly, where it softens the dielectric layer and enables affected regions of the dielectric layer to be washed away.

Inherently, the size and spacing of the vias affects the circuit density that can be achieved for the multilayer circuit. In terms of diffusion patterned vias, volume and placement of the imaging paste must be precisely controlled to prevent adjacent vias from merging, which would result in electrical shorting between the metallized or filled vias. The difficulty with which via separation is maintained is complicated by the countervailing concern that sufficient imaging paste is deposited to ensure that the vias extend completely through the dielectric layer being patterned. Because imaging pastes diffuse in all directions (laterally and downwardly) at approximately the same rate, the size of a via produced by diffusion patterning is dependent on the thickness of the dielectric layer being imaged. Therefore, vias must be spaced sufficiently apart to ensure that adjacent vias will not merge as a result of lateral interdiffusion of the imaging paste occurring during the time required for the paste to diffuse entirely through the dielectric layer.

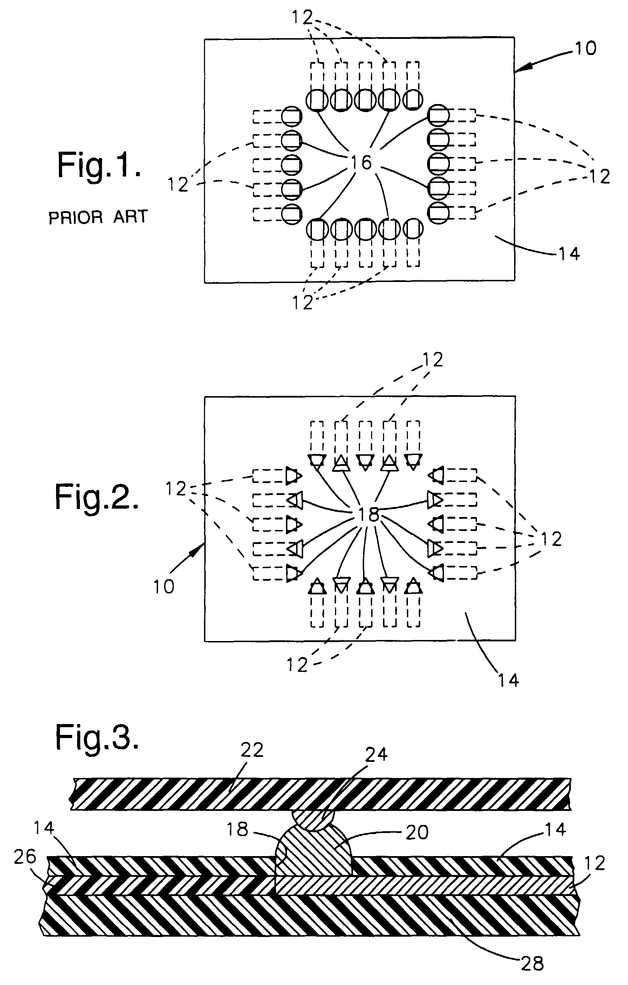

Via size and spacing is particularly critical when used to interconnect an underlying conductor pattern to a circuit component, such as a flip chip, at the surface of the circuit. Flip chips are generally monolithic semiconductor devices having terminals formed on one surface of the chip. The terminals of the chip are physically and electrically attached to a complementary conductor pattern on or beneath the surface of a circuit board. A prior art flip chip conductor pattern 10 formed on an underlying layer of a multilayer circuit is represented in Figure 1. The conductor pattern 10 is shown as being formed by a number of conductor traces 12 beneath a dielectric layer 14 that overlies a conductor layer that includes the traces 12. As shown, a via 16 is formed at the terminal end of each conductor trace 12. After the vias 16 are formed, a suitable electrically-conductive fill material (not shown), such as a thick film metallization, is deposited in the vias 16. Thereafter, a flip chip is registered with the conductor pattern 10 such that each terminal of the flip chip individually registers with the fill material in one of the vias 16.

Due to the numerous functions typically performed by the microcircuitry of a flip chip, a relatively large number of complementary vias and flip chip terminals are required. As evidenced by Figure 1, conductor patterns are conventionally configured to register with a flip chip whose terminals are located at the perimeter of the chip. The size of a typical flip chip is generally on the order of a few millimeters per side, resulting in the vias 16 being crowded within a perimetrical shape that corresponds to the location of the flip chip terminals at the perimeter of the chip. In the prior art, trace pitches, and therefore minimum flip chip terminal pitch and flip chip size, have been limited by minimum via spacing and size requirements.

As noted above, diffusion patterned vias 16 must be sufficiently spaced to prevent adjacent vias 16 from merging into each other during their formation, while via size is dependent on the conflicting requirement that the vias 16 extend entirely through the dielectric layer 10, necessitating that a sufficient amount of imaging paste be used for each via. For flip chip applications, vias 16 must also be sufficiently large to accommodate an amount of fill material that will ensure that the flip chip is sufficiently supported above the surface of the dielectric layer 14 to allow underfill by an epoxy or another suitable underfill material. The maximum amount of fill material that can be accommodated is determined by the size of the vias 16 and the surface tension of the fill material.

As a result of the above constraints, minimum spacing between conductor traces 12 of conductor patterns 10 for flip chips is typically about 0.125 millimeter (about 0.005 inch), with minimum widths for traces 12 typically being about 0.125 millimeter (about 0.005 inch) to yield a minimum trace pitch of about 0.25 millimeter (about 0.010 inch). More narrowly-spaced conductor traces 12 have been difficult to achieve because the vias 16 required to permit the use of an adequate amount of fill material must typically be about 0.2 millimeter (about 0.008 inch) in diameter, yielding a distance between vias 16 of only about 0.05 millimeter (about 0.002 inch) for a trace pitch of 0.25 millimeter. Under these circumstances, there is insufficient dielectric material remaining between adjacent vias 16 to ensure that the vias 16 will not merge during diffusion of the imaging paste, and later maintain their integrity during fill and flip chip attachment.

Accordingly, it would be desirable if a method were available that enabled relatively large vias to be used with fine pitch conductor traces, e.g., traces spaced apart about 0.125 millimeter or less, while substantially avoiding the risk of adjacent vias becoming merged during the via forming process.

### Summary of the Invention

It is an object of this invention to provide a method for forming vias in dielectric materials, in which the method minimizes via spacing while maintaining a sufficient amount of dielectric between adjacent vias to maintain the physical integrity of the vias.

It is another object of this invention that the vias are configured to reduce the likelihood of adjacent vias merging during their formation by a diffusion patterning process.

It is yet another object of this invention that the method is suitable for forming a conductor pattern for an integrated circuit device, such as a flip chip, wherein the conductor pattern is configured to permit reduced spacing between terminals disposed at the perimeter of the flip chip.

It is still another object of this invention that the method is suitable for forming the vias for such a conductor pattern, in which via size is optimized to permit the use of an adequate amount of fill material to physically support the flip chip above the surface of the dielectric layer.

The present invention provides a method for optimizing via size and spacing between vias of a via pattern formed in a dielectric layer of a multilayer circuit. The vias of this invention are particularly suited for being formed by diffusion patterning techniques, in which a diffusion imaging paste is deposited and diffused into the dielectric material, followed by development of the vias. The method is applicable to dielectric materials in the form of a dielectric tape that is applied to a multilayer circuit after formation of the vias, or a thick film that is deposited on a multilayer circuit prior to formation of the vias. As is typical, the vias preferably extend completely through the dielectric material, and are metallized or filled for the purpose of electrically interconnecting adjacent conductor layers of the multilayer circuit or a conductor layer with an integrated circuit device located at the surface of the multilayer circuit.

The objects of this invention are achieved by configuring the vias of the via pattern to have triangular shapes. More particularly, at least two immediately adjacent vias of the via pattern are formed to have a triangular shape, so as to be characterized by a base side and two lateral sides that intersect to define a point. The points of the adjacent vias face in opposite directions, such that the vias are interdigitized.

While vias configured in accordance with this invention are applicable to a variety of applications, the advantages of the invention are particularly applicable to conductor patterns for flip chips and other integrated circuit device. In this regard, the method entails configuring the vias to maximize spacing between vias, while also providing sufficient via surface area in order to ensure that an adequate amount of fill material will be present to support the circuit device above the surface of the dielectric layer. The vias form a pattern that is complementary to a terminal pattern at the perimeter of an integrated circuit device, such as a flip chip. Because the via pattern is complementary to a perimetrical terminal pattern, the via pattern defines perimetrically inboard and outboard regions in the dielectric material. According to the invention, at least two immediately adjacent vias of the via pattern have a triangular shape, with the point of one of the adjacent vias facing the outboard region of the dielectric material, while the point of the second via faces the inboard region. Again, the result is a via pattern with interdigitized vias.

As is conventional when attaching a flip chip to a substrate, the via pattern forms part of a conductor pattern that includes traces lying in the outboard region of the dielectric material, with each trace extending perimetrically outward from a corresponding via. As is also conventional, an electrically-conductive fill material is disposed in each of the vias and electrically contacts each of their associated traces. The fill material serves to electrically and physically connect the flip chip to the conductor pattern after registration of the flip chip, and support the chip above the surrounding surface of the dielectric layer.

According to this invention, the triangular shape of the vias enables the vias to be interdigitized, such that relatively large vias can be formed close together while maintaining the integrity of the vias. Specifically, interdigitizing the triangular vias provides for spacing between adjacent vias that approaches or is less than the spacing between traces associated with the vias, yet maintains a sufficient amount of dielectric between adjacent vias to maintain their physical integrity. In addition, vias of a conductor pattern for a flip chip can be formed to have surface areas that are sufficiently sized to accommodate an amount of fill material that will support the flip chip above the substrate.

Other objects and advantages of this invention will be better appreciated from the following detailed description.

### Brief Description of the Drawings

The present invention will now be described, by way of example, with reference to the accompanying drawings, in which:
Figure 1 is a plan view of a dielectric material in which vias have been developed in accordance with the prior art;
Figure 2 is a plan view of a dielectric material in which vias have been developed in accordance with this invention; and
Figure 3 is a cross-sectional view of a multilayer circuit in which a flip chip is attached to an underlying conductor trace through a via formed in accordance with this invention.

### Detailed Description of the Invention

With reference to Figure 2, there is illustrated a dielectric material 14 in which a number of vias 18 are formed in accordance with this invention. Figure 2 also represents the manner in which a corresponding number of conductor traces 12 disposed above or beneath the dielectric material 14 would be provided to form a conductor pattern 10 that is complementary to a via pattern formed by the vias 18. The dielectric material 14 may be a dielectric tape or a thick film, and generally would form a dielectric layer of a multilayer circuit.

Shown in Figure 3 is a particular application for the present invention of Figure 2, in which a terminal 24 of a flip chip 22 is shown as being electrically interconnected to one of the conductor traces 12 with an electrically-conductive fill material 20 deposited in one of the vias 18. As depicted, the conductor trace 12 is patterned in a dielectric layer 26 overlying a substrate 28. The substrate 28 may be any suitable material, though preferred materials are those typically employed to form a multilayer circuit.

Referring again to Figure 2, the conductor pattern 10 is shown as being identical to that of the prior art of Figure 1, though the present invention should not be interpreted as being limited in scope to the embodiment of Figure 2. The vias 18 are formed at the terminal end of each conductor trace 12, such that the via pattern defines perimetrically inboard and outboard regions on the dielectric layer 14. The vias 18 can be metallized to electrically interconnect the conductor traces 12 with other conductor traces of a conductor layer that overlies or underlies the dielectric layer 14. Alternatively, and as shown in Figure 3, the vias 18 can be filled with a volume of electrically-conductive fill material 20 to electrically interconnect the traces 12 with the terminals of an integrated circuit device, such as the flip chip 22, located at the surface of the dielectric layer 14.

As shown in Figure 2, vias 18 configured in accordance with this invention are triangular-shaped, which in accordance with this invention is to be understood as including a base side and two lateral sides that intersect to define a point (those skilled in the art will appreciate that the "point" of a via 18 may have an appreciable radius as a result of physical and processing limitations). While equilateral-shaped vias 18 are shown in Figure 2, it is foreseeable that their shape could be that of an isosceles or scalene triangle. According to the present invention, such triangular-shaped vias 18 can be interdigitized to enable finer pitch vias 18 and traces 12 without resulting in adjacent vias 18 merging during their formation. As used here, the vias 18 are interdigitized in the sense that the points of two immediately adjacent vias 18 face in opposite directions, e.g., a first toward the outboard region of the dielectric layer 14 and the second toward the inboard region of the dielectric layer 14. As a result, the point of each via 18 faces in an opposite direction relative to each of its immediately adjacent vias 18.

From Figure 2, it can be seen that the spacing between a given pair of adjacent vias 18, i.e., the distance between vias 18 as measured in a direction perpendicular to their opposing lateral sides, is approximately equal to the spacing between their corresponding traces 12. For example, a fine pitch conductor pattern may have traces 12 with a width of about 0.125 millimeter (about 0.005 inch) on a pitch of about 0.25 millimeter (about 0.010 inch), resulting in an inter-trace spacing of about 0.125 millimeter. In accordance with the invention, the vias 18 can have a base length of about 0.20 millimeter, a height (the distance from the base to the point) of about 0.25 millimeter, with spacing between adjacent vias 18 being about 0.125 millimeter - i.e., approximately the same as the spacing between adjacent traces 12.

In accordance with the flip chip application shown in Figure 3, the surface area provided by a via 18 configured in accordance with this invention is able to accommodate a sufficient volume of fill material 20 to ensure that the flip chip 22 will be supported sufficiently above the surface of the dielectric layer 14 to enable underfilling of the chip 22 by a suitable underfill material (not shown), such as an epoxy, as well as reliably adhere the flip chip 22 to the conductor traces 12. In the example above, the vias 18 have a surface area of about 0.025 mm². In comparison, conventionally-shaped vias of the type shown in Figure 1 having an equal surface area would have an inter-via spacing of only about 0.07 millimeter - roughly only 60% of that for vias 18 formed in accordance with this invention. At such distances, there is a much greater likelihood that the integrity of individual vias will be reduced and that adjacent vias will merge during their formation, leading to electrical shorts between adjacent volumes of fill material.

A preferred method for forming the vias 18 of this invention is a diffusion patterning (DP) technique, which utilizes a diffusion imaging paste, such as Q95IP available from DuPont de Nemours, E. I., Co. To form the vias 18, such pastes are deposited on the dielectric layer 14, after which the paste diffuses into the dielectric material 14, both laterally and downwardly at roughly equal rates, causing the dielectric material to soften such that the vias 18 are developed by simply removing those portions of the dielectric layer 14 that were softened by the paste. The above diffusion and development steps are known in the art, and therefore will not be discussed in further detail.

Diffusion patterning techniques can be used with dielectric materials in the form of a tape or thick film. In a dielectric tape, the vias 18 are developed prior to the tape being applied or laminated to a conductor layer that includes the traces 12, as shown in Figure 3. In a dielectric thick film, the vias 18 are formed after the thick film has been deposited on the conductor layer. As is known in the art, in order to achieve a completely diffused via 18, i.e., a via extending completely through the dielectric layer 14 to the traces 12, a minimum volume of imaging paste must be applied to the dielectric layer 14. In the prior art, the requirement for depositing a relatively large amount of imaging paste to fully develop vias that extend completely through a dielectric layer of a multilayer circuit conflicted with the simultaneous requirement that adjacent vias remain singular and not merged after development. As discussed above, vias 18 configured according to this invention are able to be developed to have a relatively large size while remaining sufficiently spaced apart to avoid the occurrence of adjacent vias 18 becoming merged during the development process. In the application shown in Figure 3, the vias 18 can be readily sized to accommodate an adequate volume of fill material 20 that will support the flip chip 22 above the surface of the dielectric layer 14.

In view of the above, the triangular-shaped vias 18 of this invention can be seen to greatly improve processing yields by facilitating the formation of appropriately-sized and developed vias in a dielectric material, whose integrity is maintained during subsequent processing and handling. The triangular shape of the vias 18 enables the formation of an interdigitized via pattern, in which relatively large vias 18 are formed close together while maintaining their individual integrity. Notably, interdigitized triangular vias 18 of this invention can have an inter-via spacing that approaches or is less than the spacing between the traces 12 associated with the vias 18, yet results in vias 18 whose surface areas are sufficiently sized to accommodate an amount of fill material that is adequate to support a flip chip above the surrounding surface of the circuit substrate. Furthermore, the triangular-shaped vias 18 of this invention are particularly suited to being formed in a dielectric tape by diffusion patterning techniques, which are highly suited for mass production techniques.

While our invention has been described in terms of a preferred embodiment, it is apparent that other forms could be adopted by one skilled in the art. For example, the conductor and via patterns could differ from those shown in the Figures, and appropriate materials could be substituted for those noted. Accordingly, the scope of our invention is to be limited only by the following claims.

## Claims

1. A dielectric material having a via pattern formed therein, at least two vias of the via pattern being immediately-adjacent each other, each of the two vias having a triangular shape characterized by a base side and two lateral sides that intersect to define a point, the points of the two vias facing in opposite directions such that the two vias are interdigitized.

2. A dielectric material as recited in claim 1 wherein each via of the via pattern has a triangular shape characterized by a base side and two lateral sides that intersect to define a point, the point of each via facing in an opposite direction relative to each immediately adjacent via such that all of the vias in the dielectric material are interdigitized.

3. A dielectric material as recited in claim 1 wherein the via pattern is complementary to a perimetrical terminal pattern of an integrated circuit device, the via pattern defining a perimetrically inboard region and a perimetrically outboard region of the dielectric material, the point of a first via of the two vias facing the outboard region and the point of a second via of the two vias facing the inboard region.

4. A dielectric material as recited in claim 1 further comprising an electrically-conductive material disposed within each of the vias.

5. A dielectric material as recited in claim 1, wherein the dielectric material is a tape.

6. A dielectric material as recited in claim 1, wherein the dielectric material is a thick film layer.

7. A multilayer circuit comprising: a conductor pattern comprising conductor traces; a dielectric material overlying the conductor pattern; and a via pattern comprising vias that extend through the dielectric layer to the conductor pattern, the via pattern being complementary to the conductor pattern and a terminal pattern of an integrated circuit device, the via pattern defining a perimetrically inboard region and a perimetrically outboard region in the dielectric material, at least two of the vias being immediately adjacent each other, each of the two vias having a triangular shape characterized by a base side and two lateral sides that intersect to define a point, the point of a first via of the two vias facing the outboard region and the point of a second via of the two vias facing the inboard region such that the first and second vias are interdigitized.

8. A multilayer circuit as recited in claim 7, wherein each of the vias has a triangular shape characterized by a base side and two lateral sides that intersect to define a point, the point of each via facing in an opposite direction relative to each immediately adjacent via such that all of the vias in the dielectric material are interdigitized.

9. A multilayer circuit as recited in claim 7 further comprising conductive material electrically contacting each of the conductor traces through the vias.

10. A multilayer circuit as recited in claim 7 wherein the conductor traces are adjacent to the outboard region of the dielectric material, each of the conductors extending perimetrically outward from a corresponding one of the vias.

11. A multilayer circuit as recited in claim 7, wherein each of the vias has an area of at least about 0.025 mm² and wherein the vias are spaced apart not more than about 0.125 mm.

12. A multilayer circuit as recited in claim 11, wherein each of the conductor traces has a width of about 0.125 mm and adjacent conductor traces are spaced apart not more than about 0.125 mm.

13. A method for forming a via pattern in a dielectric material, the method comprising the steps of: providing a dielectric material; and forming vias in the dielectric material so as to define a via pattern having at least two vias that are immediately-adjacent each other, each of the two vias having a triangular shape characterized by a base side and two lateral sides that intersect to define a point, the points of the two vias facing in opposite directions such that the two vias are interdigitized.

14. A method as recited in claim 13, further comprising the step of forming the dielectric material as a tape and applying the tape to a conductor layer after the step of forming the vias therein.

15. A method as recited in claim 13, further comprising the step of forming the dielectric material as a thick film on a conductor layer prior to the step of forming the vias.

16. A method as recited in claim 13, wherein the vias are formed to extend through the dielectric material so as to expose conductor traces of an underlying conductor layer of a multilayer circuit.

17. A method as recited in claim 16, further comprising the step of forming the via pattern to be complementary to a terminal pattern of an integrated circuit device, the via pattern defining a perimetrically inboard region and a perimetrically outboard region on the dielectric material, the point of a first via of the two vias facing the outboard region and the point of a second via of the two vias facing the inboard region.

18. A method as recited in claim 17, further comprising the step of filling the vias with an electrically-conductive material such that the material within each via contacts a corresponding one of the conductor traces.

19. A method as recited in claim 18, further comprising the step of registering an integrated circuit device with the via pattern such that terminals of the terminal pattern register with the vias.

20. A method as recited in claim 13 wherein the step of forming the vias is a diffusion patterning technique comprising the steps of depositing a diffusion imaging material on the dielectric material, diffusing the diffusion imaging material into the dielectric material, and then developing the vias.
